# EUROPEAN PATENT SPECIFICATION

(11) **EP 4 125 142 B1**
(45) Date of publication and mention of the grant of the patent: **13.05.2026**
(21) Application number: 22186846.6
(22) Date of filing: 26.07.2022
(51) Int. Cl.: H10K 59/80, H10K 59/38

(54) **DISPLAY APPARATUS**
ANZEIGEVORRICHTUNG
APPAREIL D'AFFICHAGE

(30) Priority: 28.07.2021 KR 20210099437
(43) Date of publication of application: 01.02.2023
(73) Proprietor: Samsung Display Co., Ltd., Yongin-si, Gyeonggi-do 17113 (KR)
(72) Inventor: Kim, Woongsik, 17113 Giheung-gu, Yongin-si, Gyeonggi-do (KR); Hong, Jongbeom, 17113 Giheung-gu, Yongin-si, Gyeonggi-do (KR); Kim, Jeongwon, 17113 Giheung-gu, Yongin-si, Gyeonggi-do (KR); Byun, Jinsu, 17113 Giheung-gu, Yongin-si, Gyeonggi-do (KR)
(74) Representative: Dr. Weitzel & Partner

(56) References cited:
- JP-A- 2015 128 027
- KR-A- 20200 083 875
- US-A1- 2016 064 694
- US-A1- 2019 221 778
- US-A1- 2019 221 779
- US-A1- 2020 303 466
- US-A1- 2020 350 516

## Description

### BACKGROUND

### FIELD

The present invention relates to a display apparatus.

### DISCUSSION OF THE BACKGROUND

Recently, the usage of display apparatuses has diversified. Also, display apparatuses have become thinner and more lightweight, and thus the use of display apparatuses has expanded. As display apparatuses are used in various fields, the demand for display apparatuses that provide high-quality images is increasing.

US 2019/221779 A1 discloses a display device including: a display portion including pixels defined by a pixel defining layer; and a touch portion on the display portion. The touch portion includes: a first touch electrode overlapping the pixel defining layer; a first organic layer on the first touch electrode; a second touch electrode contacting the first touch electrode; a second organic layer on the second touch electrode; and a high refractive index layer on the first organic layer, the second touch electrode, and the second organic layer. The high refractive index layer is disposed between adjacent second touch electrodes in a plan view and includes a first convex surface protruding toward the display portion and overlapping one of the pixels.

KR 2020 0083875 A discloses a display device comprising: a first substrate including a plurality of pixels; a second substrate facing the first substrate; and an optical path change layer disposed between the first substrate and the second substrate and including a first pattern portion and a second pattern portion. The first pattern portion has a first refractive index and the second pattern portion has a second refractive index smaller than the first refractive index. The first pattern portion includes a blue colorant.

US 2019/221778 A1 discloses an organic light-emitting display device including a substrate; a first organic light-emitting layer disposed on the substrate; a pixel defining film disposed on the first organic light-emitting layer and having a first opening, which at least partially exposes the first organic light-emitting layer; and an optical path converter disposed on the pixel defining film to overlap with the first organic light-emitting layer and including a first optical path converting member, which has a first refractive index, and a second optical path converting member, which has a second refractive index that is lower than the first refractive index.

The above information disclosed in this Background section is only for understanding of the background of the inventive concepts, and, therefore, it may contain information that does not constitute prior art.

### SUMMARY

Devices constructed according to the invention are capable of improved light extraction efficiency and visibility by providing a refractive layer and a light blocking layer on a lower surface of an encapsulation substrate.

Inventive concepts consistent with one or more embodiments provide for a display apparatus in which light efficiency and visibility are improved to allow high-quality images to be provided. However, this is merely an example, and the scope of the disclosure is not limited thereby.

The present invention is defined by a display apparatus with the features of claim 1. The dependent claims describe preferred embodiments.

Additional features of the inventive concepts will be set forth in the description that follows, and in part will be apparent from the description, or may be learned by practice of the inventive concepts.

When used herein, the term width refers to the width in a cross-sectional view through the display substrate and the encapsulation substrate and the parts between these substrates. The cross-sectional view is in a plane extending in the thickness direction (z direction) of the display apparatus and in the extending direction of the substrates, e.g. the extending direction through the emission areas and the non-emission areas.

In some embodiments, an angle at which a side surface of the second insulating layer is inclined with respect to a lower surface of the encapsulation substrate may be about 50° to about 60°.

In some embodiments, the first refractive index may be about 1.45 to about 1.55, and the second refractive index is about 1.55 to about 1.7.

In some embodiments, the second insulating layer may include a color filter.

In some embodiments, the second insulating layer may include a reflection control layer configured to selectively absorb a first wavelength band and a second wavelength band of a visible light band.

In some embodiments, the first wavelength band may be about 480 nm to about 505 nm, and the second wavelength band may be about 585 nm to about 605 nm.

In some embodiments, the width of a respective opening of the light blocking layer may be greater than the width of the upper surface of the second insulating layer.

In some embodiments, a thickness of the light blocking layer may be less than a thickness of the first insulating layer.

According to an embodiment of the present invention, a display apparatus includes a display substrate, a first display element, a second display element, and a third display element, which are on the display substrate and are configured to emit light of different colors, an encapsulation substrate on the first display element, the second display element, and the third display element to face the display substrate, a light blocking layer below the encapsulation substrate, the light blocking layer including openings corresponding to emission areas of the first display element, the second display element, and the third display element, and a refractive layer between the encapsulation substrate and the light blocking layer, the refractive layer including a first insulating layer having a first refractive index and a second insulating layer having a second refractive index greater than the first refractive index, wherein the second insulating layer is arranged to correspond to the emission areas of the first display element, the second display element, and the third display element, and a width of an upper surface of the second insulating layer, that is an upper surface of the second insulating layer in an emission area or in each of the emission areas, is less than a width of a lower surface of the second insulating layer in the respective emission area.

In some embodiments, an angle at which a side surface of the second insulating layer is inclined with respect to a lower surface of the encapsulation substrate may be about 50° to about 60°.

In some embodiments, the first refractive index may be about 1.45 to about 1.55, and the second refractive index may be about 1.55 to about 1.7.

In some embodiments, the second insulating layer may include a first color filter, a second color filter, and a third color filter configured to emit different colors from each other, and the first color filter, the second color filter, and the third color filter may be arranged to correspond to the first display element, the second display element, and the third display element, respectively.

In some embodiments, the second insulating layer may include a reflection control layer configured to selectively absorb a first wavelength band and a second wavelength band of a visible light band.

In some embodiments, the first wavelength band may be about 480 nm to about 505 nm, and the second wavelength band may be about 585 nm to about 605 nm.

In some embodiments, the second insulating layer may be provided as a common part on the first display element, the second display element, and the third display element.

In some embodiments, the second insulating layer may extend between the first, second, and third display elements and the light blocking layer.

In some embodiments, a width of a respective opening of the light blocking layer may be greater than the width of the upper surface of the second insulating layer.

It is to be understood that both the foregoing general description and the following detailed description are illustrative and explanatory and are intended to provide further explanation of the invention as claimed.

### BRIEF DESCRIPTION OF THE DRAWINGS

The accompanying drawings, which are included to provide a further understanding of the invention and are incorporated in and constitute a part of this specification, illustrate illustrative embodiments of the invention, and together with the description serve to explain the inventive concepts.
FIG. 1 is a perspective view schematically illustrating a portion of a display apparatus according to an embodiment that is constructed according to principles of the invention.
FIG. 2 is a cross-sectional view of the display apparatus taken along line I-I' of FIG. 1, according to an embodiment.
FIG. 3 is a plan view schematically illustrating a display apparatus according to an embodiment.
FIG. 4 illustrates a display element and a pixel circuit connected thereto in a pixel of a display apparatus, according to an embodiment.
FIGS. 5A and 5B are enlarged plan views of some elements that may be included in region A of FIG. 3, according to an embodiment.
FIGS. 6A and 6B are schematic cross-sectional views of the display apparatus taken along line II-II' of FIG. 5A, according to an embodiment not forming part of the claimed invention.
FIG. 7 illustrates transmittance characteristics when a second insulating layer is provided as a reflection control layer.
FIG. 8 is a cross-sectional view schematically illustrating a portion of a display apparatus according to an embodiment.
FIG. 9 is a cross-sectional view schematically illustrating a portion of a display apparatus according to an embodiment not forming part of the claimed invention.
FIG. 10 is a cross-sectional view schematically illustrating a portion of a display apparatus according to an embodiment not forming part of the claimed invention.
FIG. 11 is a cross-sectional view schematically illustrating a portion of a display apparatus according to an embodiment not forming part of the claimed invention.

### DETAILED DESCRIPTION

In the following description, for the purposes of explanation, numerous specific details are set forth in order to provide a thorough understanding of various embodiments or implementations of the invention. As used herein "embodiments" and "implementations" are interchangeable words that are non-limiting examples of devices or methods employing one or more of the inventive concepts disclosed herein. It is apparent, however, that various embodiments may be practiced without these specific details or with one or more equivalent arrangements. In other instances, well-known structures and devices are shown in block diagram form in order to avoid unnecessarily obscuring various embodiments. Further, various embodiments may be different, but do not have to be exclusive. For example, specific shapes, configurations, and characteristics of an embodiment may be used or implemented in another embodiment without departing from the inventive concepts.

Unless otherwise specified, the illustrated embodiments are to be understood as providing illustrative features of varying detail of some ways in which the inventive concepts may be implemented in practice. Therefore, unless otherwise specified, the features, components, modules, layers, films, panels, regions, and/or aspects, etc. (hereinafter individually or collectively referred to as "elements"), of the various embodiments may be otherwise combined, separated, interchanged, and/or rearranged without departing from the inventive concepts.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified. Further, in the accompanying drawings, the size and relative sizes of elements may be exaggerated for clarity and/or descriptive purposes. When an embodiment may be implemented differently, a specific process order may be performed differently from the described order. For example, two consecutively described processes may be performed substantially at the same time or performed in an order opposite to the described order. Also, like reference numerals denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the x-axis, the y-axis, and the z-axis are not limited to three axes of a rectangular coordinate system, and may be interpreted in a broader sense. For example, the x-axis, the y-axis, and the z-axis may be perpendicular to one another, or may represent different directions that are not perpendicular to one another. For the purposes of this disclosure, "at least one of X, Y, and Z" and "at least one selected from the group consisting of X, Y, and Z" may be construed as X only, Y only, Z only, or any combination of two or more of X, Y, and Z, such as, for instance, XYZ, XYY, YZ, and ZZ. As used herein, the term "and/or" includes any and all combinations of one or more of the associated listed items.

Although the terms "first," "second," etc. may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (e.g., as in "sidewall"), and the like, may be used herein for descriptive purposes, and, thereby, to describe one elements relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below" can encompass both an orientation of above and below. Furthermore, the apparatus may be otherwise oriented (e.g., rotated 90 degrees or at other orientations), and, as such, the spatially relative descriptors used herein interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various embodiments are described herein with reference to sectional and/or exploded illustrations that are schematic illustrations of idealized embodiments and/or intermediate structures. As such, variations from the shapes of the illustrations as a result, for example, of manufacturing techniques and/or tolerances, are to be expected. Thus, embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

Unless otherwise defined, all terms (including technical and scientific terms) used herein have the same meaning as commonly understood by one of ordinary skill in the art to which this disclosure is a part. Terms, such as those defined in commonly used dictionaries, should be interpreted as having a meaning that is consistent with their meaning in the context of the relevant art and should not be interpreted in an idealized or overly formal sense, unless expressly so defined herein.

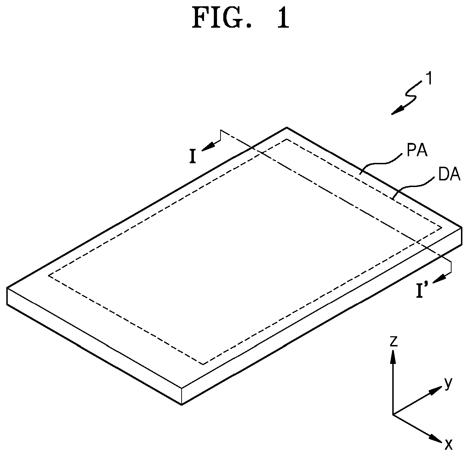

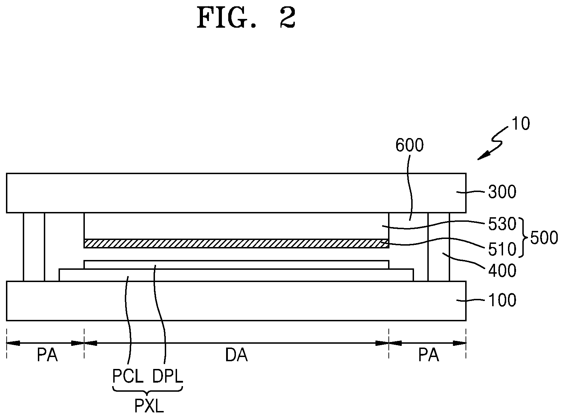

FIG. 1 is a perspective view schematically illustrating a portion of a display apparatus 1 according to an embodiment that is constructed according to principles of the invention. FIG. 2 is a cross-sectional view of the display apparatus 1 taken along line I-I' of FIG. 1, according to an embodiment.

Referring to FIG. 1, the display apparatus 1 according to an embodiment may include a display area DA and a peripheral area PA. The peripheral area PA is outside the display area DA and surrounds the display area DA. Various lines and driving circuits configured to transmit electric signals to the display area DA may be in the peripheral area PA. The display apparatus 1 may provide a certain image by using light emitted from a plurality of pixels in the display area DA.

Examples of the display apparatus 1 may include an organic light-emitting display, an inorganic light-emitting display (or an organic electroluminescence (EL) display), or a quantum dot light-emitting display. Hereinafter, an organic light-emitting display will be described as an example. The display apparatus 1 may be implemented as various types of electronic apparatuses such as mobile phones, laptops, and smart watches.

As illustrated in FIG. 2, the display apparatus 1 may include a display substrate 100 and an encapsulation substrate 300, which are sequentially stacked in a third direction (z direction). The encapsulation substrate 300 encapsulates the display substrate 100.

The display substrate 100 may include a glass material or a polymer resin. For example, the display substrate 100 may include a glass material including SiO₂ as a main component or a resin such as reinforced plastic.

A pixel layer PXL may be on the display substrate 100. The pixel layer PXL may include a display element layer DPL and a pixel circuit layer PCL. The display element layer DPL may include display elements arranged for each pixel, and the pixel circuit layer PCL may include a pixel circuit and insulating layers arranged for each pixel. The display element layer DPL may above the pixel circuit layer PCL, and the insulating layers may be between the pixel circuit and the display element. Some lines and insulating layers of the pixel circuit layer PCL may extend to the peripheral area PA.

The encapsulation substrate 300 may be arranged to face the display substrate 100, and may be bonded to the display substrate 100 by an encapsulation member 400. The encapsulation substrate 300 and the encapsulation member 400 may prevent infiltration of external moisture, air, or the like into the pixel layer PXL including the display elements. The encapsulation substrate 300 may include a glass material or a polymer resin. For example, the encapsulation substrate 300 may include a glass material having SiO₂ as a main component or a resin such as reinforced plastic. The encapsulation member 400 may be arranged to surround the display area DA in the peripheral area PA. The encapsulation member 400 may include a sealant or frit, and may be cured by heat and/or laser to bond the display substrate 100 to the encapsulation substrate 300.

An optical layer 500 may be on the lower surface of the encapsulation substrate 300, that is, on the surface facing the display substrate 100. The optical layer 500 may include an element configured to reduce the reflectance of light (external light) incident from the outside toward the display apparatus 1 and improve the light output efficiency of light emitted from the display elements.

The optical layer 500 may include a light blocking layer 510 including a black matrix, and a refractive layer 530. The light blocking layer 510 may be configured to block most of visible light, and the refractive layer 530 may include members having different refractive indices from each other so as to increase light extraction efficiency. According to the embodiment described herein, because the display apparatus 1 includes the optical layer 500, the display apparatus 1 may not use a polarizing film. Therefore, luminance may be increased, or power consumption may be reduced.

A filling member 600 may be between the display substrate 100 and the encapsulation substrate 300. The filling member 600 may be between the pixel layer PXL and the encapsulation substrate 300. The filling member 600 may be configured to protect the pixel layer PXL from an impact that may be applied from the outside. The filling member 600 may include a transparent insulating material. In some embodiments, the filling member 600 may include an organic sealant such as urethane resin, epoxy resin, or acrylic resin, or may include an inorganic sealant such as silicone. Examples of the urethane resin may include urethane acrylate. Examples of the acrylic resin may include butyl acrylate and ethylhexyl acrylate. In some embodiments, the filling member 600 may include polyimide. In some embodiments, the filling member 600 may be omitted. When the filling member 600 is omitted, air may be filled between the pixel layer PXL and the encapsulation substrate 300.

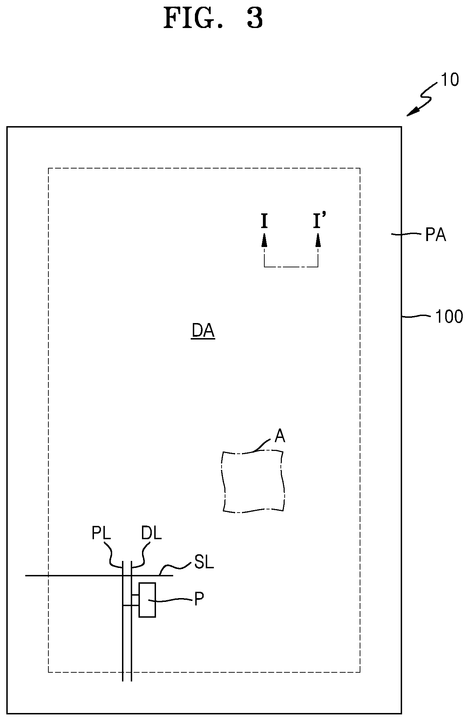

FIG. 3 is a plan view schematically illustrating a display apparatus 10 according to an embodiment.

Referring to FIG. 3, a display substrate 100 of the display apparatus 10 may be divided into a display area DA and a peripheral area PA around the display area DA. The display apparatus 10 may provide a certain image by using light emitted from a plurality of pixels P in the display area DA.

Each of the pixels P may include a display element such as an organic light-emitting diode or an inorganic light-emitting diode, and may emit, for example, red light, green light, blue light, or white light. That is, each of the pixels P may be connected to a pixel circuit including a thin-film transistor (TFT), a storage capacitor, and the like. The pixel circuit may be connected to a scan line SL, and a data line DL and a driving voltage line PL crossing the scan line SL. The scan line SL may extend in an x direction, and the data line DL and the driving voltage line PL may extend in a y direction.

Due to the driving of the pixel circuit, the pixels P may emit light. The display area DA provides a certain image according to light emitted from the pixels P. As described above, the pixel P in this specification may be defined as an emission area configured to emit red light, green light, blue light, or white light.

The peripheral area PA is an area in which the pixels P are not arranged and no image is provided. A terminal portion may be in the peripheral area PA. A printed circuit board or a driver integrated circuit (IC) including an internal driving circuit, a power supply line, and a driving circuit may be connected to the terminal portion so as to drive the pixels P.

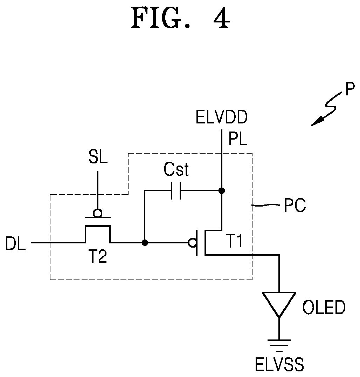

FIG. 4 illustrates a display element and a pixel circuit PC connected thereto in a pixel of a display apparatus, according to an embodiment.

Referring to FIG. 4, the display element, i.e., an organic light-emitting diode OLED, is connected to the pixel circuit PC. The pixel circuit PC may include a first thin-film transistor T1, a second thin-film transistor T2, and a storage capacitor Cst. For example, the organic light-emitting diode OLED may emit red light, green light, or blue light, or may emit red light, green light, blue light, or white light.

The second thin-film transistor T2 is a switching thin-film transistor. The second thin-film transistor T2 may be connected to a scan line SL and a data line DL, and may be configured to transmit, to the first thin-film transistor T1, a data voltage input from the data line DL according to a switching voltage input from the scan line SL. The storage capacitor Cst may be connected to the second thin-film transistor T2 and a driving voltage line PL, and may be configured to store a voltage corresponding to a difference between a voltage received from the second thin-film transistor T2 and a first power supply voltage ELVDD supplied to the driving voltage line PL.

The first thin-film transistor T1 is a driving thin-film transistor. The first thin-film transistor T1 may be connected to the driving voltage line PL and the storage capacitor Cst, and may be configured to control a driving current flowing from the driving voltage line PL to the organic light-emitting diode OLED in response to a voltage value stored in the storage capacitor Cst. The organic light-emitting diode OLED may emit light having a certain luminance according to the driving current. An opposite electrode (e.g., a cathode) of the organic light-emitting diode OLED may be configured to receive a second power supply voltage ELVSS.

FIG. 4 illustrates that the pixel circuit PC includes two thin-film transistors and one storage capacitor, but in another embodiment, the number of thin-film transistors or the number of storage capacitors may be variously changed according to the design of the pixel circuit PC.

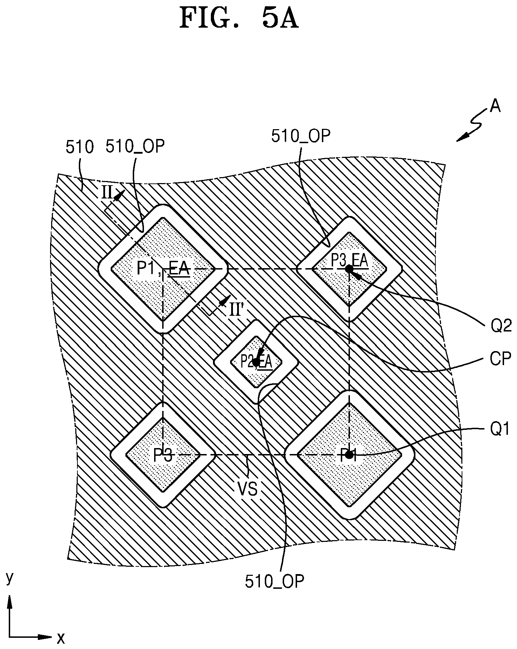

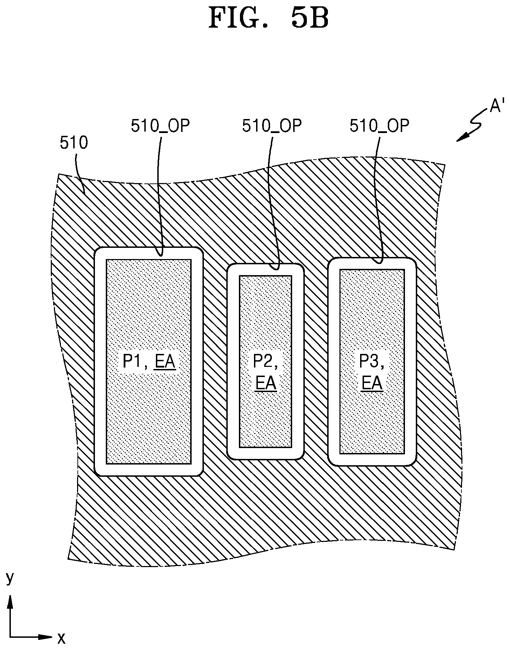

FIGS. 5A and 5B are enlarged plan views of some elements that may be included in region A of FIG. 3, according to an embodiment, and schematically illustrate the arrangement relationship between a plurality of pixels and openings 510_OP of a light blocking layer 510 arranged to correspond to emission areas EA of the pixels.

Referring to FIG. 5A, a display apparatus may include a plurality of pixels. The pixels may include a first pixel P1, a second pixel P2, and a third pixel P3, which emit light of different colors from each other. For example, the first pixel P1 may emit blue light, the second pixel P2 may emit green light, and the third pixel P3 may emit red light. However, the disclosure is not limited thereto. Various modifications may be made thereto. For example, the first pixel P1 may emit red light, the second pixel P2 may emit green light, and the third pixel P3 may emit blue light.

The first pixel P1, the second pixel P2, and the third pixel P3 may have a quadrangular shape among polygonal shapes. In this specification, the polygon or the quadrangle includes round vertices. That is, the first pixel P1, the second pixel P2, and the third pixel P3 may have a quadrangular shape with round vertices. In another embodiment, the first pixel P1, the second pixel P2, and the third pixel P3 may have a circular or elliptical shape.

The first pixel P1, the second pixel P2, and the third pixel P3 may have different sizes from each other. For example, the area of the second pixel P2 may be less than the area of the first pixel P1 and the third pixel P3, and the area of the first pixel P1 may be greater than the area of the third pixel P3. However, the disclosure is not limited thereto. Various modifications may be made thereto. The first pixel P1, the second pixel P2, and the third pixel P3 may have at least substantially the same size.

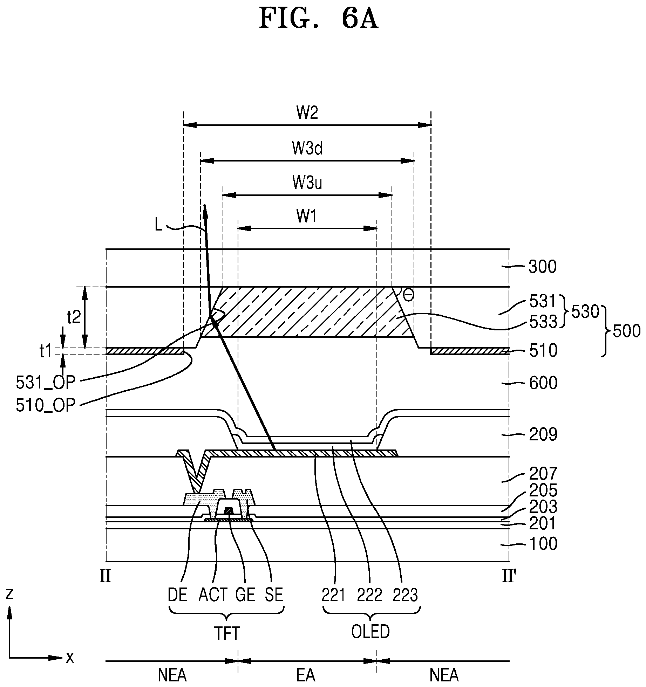

In this specification, the sizes of the first pixel P1, the second pixel P2, and the third pixel P3 refer to the size of the emission area EA of the display element implementing each pixel. The emission area EA may be defined by an opening OP of a pixel defining layer (see area designated by numeric label 209 of FIG. 6A).

On the other hand, a light blocking layer 510 on the display element layer has openings 510_OP corresponding to the respective pixels. The opening 510_OP is an area in which the light blocking layer 510 is partially removed, and light emitted from the display element may be emitted through the opening 510_OP. A body of the light blocking layer 510 may include a material that absorbs external light, and thus, the visibility of the display apparatus may be improved.

In a plan view, the openings 510_OP of the light blocking layer 510 may be arranged to surround the first, second, and third pixels P1, P2, and P3, respectively. In an embodiment, the opening 510_OP of the light blocking layer 510 may have a quadrangular shape with round corners. The areas of the openings 510_OP of the light blocking layer 510 corresponding to the first, second, and third pixels P1, P2, and P3 may be greater than the areas of the first, second, and third pixels P1, P2, and P3. However, the disclosure is not limited thereto. The areas of the openings 510_OP of the light blocking layer 510 may be at least substantially the same as the areas of the first, second, and third pixels P1, P2, and P3.

The first pixel P1, the second pixel P2, and the third pixel P3 may be arranged in a PenTile^{™} structure. The first pixel P1 may be arranged at a first vertex Q1 of a virtual quadrangle VS with a center point CP of the second pixel P2 as a center point of the quadrangle, and the third pixel P3 may be arranged at a second vertex Q2 of the virtual quadrangle VS. The virtual quadrangle VS may be a square.

The first pixel P1 may be apart from the second pixel P2, and a center point of the first pixel P1 may be located at the first vertex Q1 of the virtual quadrangle VS. A plurality of first pixels P1 may be provided, and the first pixels P1 are apart from each other with the second pixel P2 therebetween.

The third pixel P3 is apart from the first pixel P1 and the second pixel P2, and a center point of the third pixel P3 is located at the second vertex Q2 adjacent to the first vertex Q1 of the virtual quadrangle VS. A plurality of third pixels P3 may be provided, and the third pixels P3 are apart from each other with the first pixel P1 therebetween.

The first pixels P1 and the third pixels P3 may be alternately arranged in the x direction and the y direction crossing the x direction. The first pixel P1 may be surrounded by the second pixels P2 and the third pixels P3.

Although FIG. 5A illustrates that the arrangement of the first pixel P1, the second pixel P2, and the third pixel P3 has a PenTile^{™} structure, the disclosure is not limited thereto.

For example, of course, the arrangement of the first pixel P1, the second pixel P2, and the third pixel P3 may have a stripe structure, as illustrated in FIG. 5B. That is, the first pixel P1, the second pixel P2, and the third pixel P3 may be sequentially arranged in the x direction. In another embodiment, the first pixel P1, the second pixel P2, and the third pixel P3 may be arranged in various pixel arrangement structures such as a mosaic structure or a delta structure. According to the embodiment described herein, the display apparatus includes a first pixel P1, a second pixel P2, and a third pixel P3, which emit light of different colors from each other, and a light blocking layer 510 includes openings 510_OP corresponding to the first, second, and third pixels P1, P2, and P3.

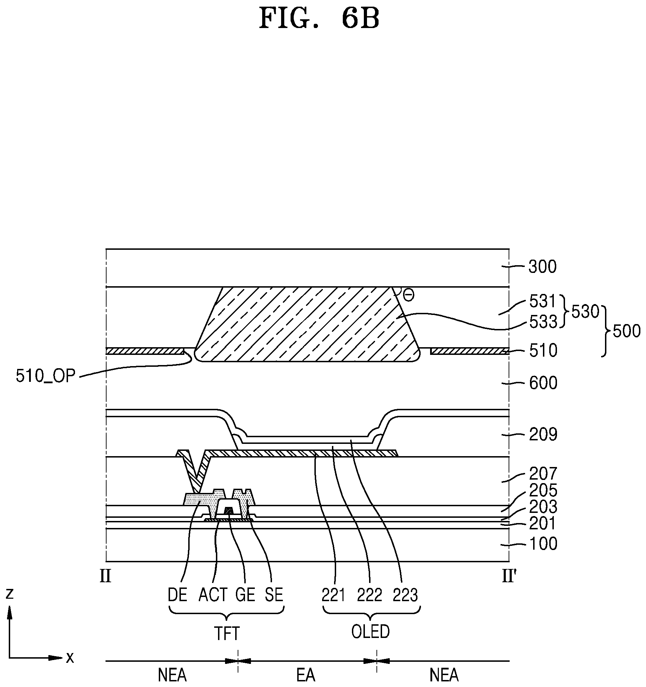

FIGS. 6A and 6B are schematic cross-sectional views of the display apparatus taken along line II-II' of FIG. 5A, according to an embodiment not forming part of the claimed invention.

Referring to FIG. 6A, the display apparatus according to an embodiment includes an organic light-emitting diode OLED as a display element including an emission area EA on a display substrate 100, an encapsulation substrate 300 encapsulating the display element, and an optical layer 500 on the lower surface of the encapsulation substrate 300.

The display substrate 100 and the encapsulation substrate 300 may include a glass material or a polymer resin. The display substrate 100 and the encapsulation substrate 300 may be rigid, and may include glass including SiO2 as a main component or a resin such as reinforced plastic.

A thin-film transistor TFT may include a semiconductor layer ACT, a gate electrode GE, a source electrode SE, and a drain electrode DE. The semiconductor layer ACT may include amorphous silicon, polycrystalline silicon, or an organic semiconductor material. In order to secure insulation between the semiconductor layer ACT and the gate electrode GE, a gate insulating layer 203 including an inorganic material such as silicon oxide, silicon nitride, and/or silicon oxynitride may be between the semiconductor layer ACT and the gate electrode GE. Also, an interlayer insulating layer 205 including an inorganic material such as silicon oxide, silicon nitride, and/or silicon oxynitride may be on the gate electrode GE, and the source electrode SE and the drain electrode DE may be on the interlayer insulating layer 205. The insulating layer including the inorganic material may be formed through chemical vapor deposition (CVD) or atomic layer deposition (ALD).

The gate electrode GE, the source electrode SE, and the drain electrode DE may include various conductive materials. The gate electrode GE may include at least one of molybdenum, aluminum, copper, and titanium, and may have a multilayer structure. For example, the gate electrode GE may have a single molybdenum layer, or may have a three-layer structure including a molybdenum layer, an aluminum layer, and a molybdenum layer. The source electrode SE and the drain electrode DE may include at least one of copper, titanium, and aluminum, and may have a multilayer structure. For example, the source electrode SE and the drain electrode DE may have a three-layer structure including a titanium layer, an aluminum layer, and a titanium layer.

A buffer layer 201 including an inorganic material such as silicon oxide, silicon nitride, and/or silicon oxynitride may be between the thin-film transistor TFT and the display substrate 100. The buffer layer 201 may increase the smoothness of the upper surface of the display substrate 100, or may prevent or minimize infiltration of impurities from the display substrate 100 or the like into the semiconductor layer ACT of the thin-film transistor TFT.

A planarization insulating layer 207 may be on the thin-film transistor TFT. The planarization insulating layer 207 may include, for example, an organic material such as acryl, benzocyclobutene (BCB), or hexamethyldisiloxane (HMDSO). In FIG. 6A, the planarization insulating layer 207 is illustrated as a single layer, but may have multiple layers.

The pixel electrode 221 may be on the planarization insulating layer 207. The pixel electrode 221 is arranged for each pixel. The pixel electrodes 221 corresponding to the neighboring pixels may be apart from each other.

The pixel electrode 221 may be a reflective electrode. In some embodiments, the pixel electrode 221 may include a reflective layer including Ag, Mg, Al, Pt, Pd, Au, Ni, Nd, Ir, Cr, and any compound thereof, and a transparent or semitransparent electrode layer on the reflective layer. The transparent or semitransparent electrode layer may include at least one selected from indium tin oxide (ITO), indium zinc oxide (IZO), zinc oxide (ZnO), indium oxide (In₂O₃), indium gallium oxide (IGO), and aluminum zinc oxide (AZO). In some embodiments, the pixel electrode 221 may have a three-layer structure including an ITO layer, an Ag layer, and an ITO layer.

A pixel defining layer 209 is on the pixel electrode 221. The pixel defining layer 209 includes an opening OP exposing the central portion of the pixel electrode 221. The pixel defining layer 209 may prevent an electric arc or the like from occurring on the edges of the pixel electrode 221 by covering the edges of the pixel electrode 221 and increasing distances between the edges of the pixel electrode 221 and portions of an opposite electrode 223. The pixel defining layer 209 may include an organic insulating material such as polyimide, polyamide, acrylic resin, benzocyclobutene, HMDSO, and phenolic resin, and may be formed by spin coating or the like. Alternatively, the pixel defining layer 209 may include an inorganic insulating material. Alternatively, the pixel defining layer 209 may have a multilayer structure including an inorganic insulating material and an organic insulating material.

In some embodiments, the pixel defining layer 209 may include a light blocking material and may be black. The light blocking material may include carbon black, carbon nanotubes, a resin or paste including black dye, metal particles (e.g., nickel, aluminum, molybdenum, and any alloy thereof), metal oxide particles (e.g., chromium oxide), or metal nitride particles (e.g., chromium nitride). When the pixel defining layer 209 includes a light blocking material, the reflection of external light due to metal structures under the pixel defining layer 209 may be reduced.

An emission layer 222 may be inside the opening OP of the pixel defining layer 209. The emission layer 222 may be an organic material including a fluorescent or phosphorescent material capable of emitting red light, green light, or red light. The organic material may include a low molecular weight organic material or a high molecular weight organic material.

A first common layer and/or a second common layer may be below and above the emission layer 222. The first common layer is below the emission layer 222, and may include, for example, a hole transport layer (HTL) or may include an HTL and a hole injection layer (HIL). The second common layer is above the emission layer 222, and may include an electron transport layer (ETL) and/or an electron injection layer (EIL). In some embodiments, the second common layer may be omitted.

The emission layer 222 is arranged for each pixel to correspond to the opening OP of the pixel defining layer 209, and the first common layer and the second common layer may be provided as one body to entirely cover the display substrate 100, for example, to entirely cover the display area of the display substrate 100, as the opposite electrode 223 to be described below.

The opposite electrode 223 may be a cathode that is an electron injection electrode. In this case, the opposite electrode 223 may include a metal, an alloy, an electrically conductive compound, or any combination thereof, which has a low work function. The opposite electrode 223 may be a transmissive electrode, a transflective electrode, or a reflective electrode.

The opposite electrode 223 may include lithium (Li), silver (Ag), magnesium (Mg), aluminum (Al), aluminum-lithium (Al-Li), calcium (Ca), magnesium-indium (Mg-In), magnesium-silver (Mg-Ag), ytterbium (Yb), silver-ytterbium (Ag-Yb), ITO, IZO, or any combination thereof. The opposite electrode 223 may have a single-layer structure or a multilayer structure including a plurality of layers.

A capping layer may be further on the opposite electrode 223. The capping layer may improve the external luminescence efficiency of the organic light-emitting element due to the principle of constructive interference. The capping layer may include a material having a refractive index of about 1.6 or more (at about 589 nm). The capping layer may have a thickness of about 1 nm to about 200 nm, for example, about 5 nm to about 150 nm, or about 10 nm to about 100 nm. The capping layer may be an organic capping layer including an organic material, an inorganic capping layer including an inorganic material, or a composite capping layer including an organic material and an inorganic material.

The encapsulation substrate 300 faces the display substrate 100 and is on the organic light-emitting diode OLED that is the display element. In the embodiment described herein, an optical layer 500 is on the lower surface of the encapsulation substrate 300. The optical layer 500 includes the light blocking layer 510 and the refractive layer 530.

In the claimed invention, the refractive layer 530 includes a first insulating layer 531 having a first refractive index and a second insulating layer 533 having a second refractive index greater than the first refractive index. The first insulating layer 531 and the second insulating layer 533 are in direct contact with the lower surface of the encapsulation substrate 300.

The second insulating layer 533 may be arranged to correspond to an emission area EA of the organic light-emitting diode OLED. The first insulating layer 531 may be arranged to correspond to a non-emission area NEA around the emission area EA.

A width W3u of the upper surface of the second insulating layer 533 may be less than a width W3d of the lower surface of the second insulating layer 533. The side surface of the second insulating layer 533 may have an inclined surface with respect to the lower surface of the encapsulation substrate 300, and an angle θ between the outer surface of the second insulating layer 533 and the lower surface of the encapsulation substrate 300 may be about 50° to 60°. The width W3d of the lower surface of the second insulating layer 533 may be greater than the width W1 of the emission area EA.

In the claimed invention, the first insulating layer 531 is arranged to correspond to the non-emission area NEA outside the emission area EA. A first refractive index, which is a refractive index of the first insulating layer 531, is less than a second refractive index, which is a refractive index of the second insulating layer 533. That is, the first insulating layer 531 may include a low refractive index material, and the second insulating layer 533 may include a high refractive index material. The refractive index of the second insulating layer 533 may be different from the refractive index of the first insulating layer 531 by about 0.05 to 0.2.

When the refractive index of the first insulating layer 531 is different from the refractive index of the second insulating layer 533, light L that is emitted from the organic light-emitting diode OLED and travels in an oblique direction with respect to the direction (z direction) perpendicular to the upper surface of the display substrate 100 may be refracted from the side surface of the first insulating layer 531 or the side surface of the second insulating layer 533 and travel to the outside of the display apparatus. Therefore, the light output efficiency of the organic light-emitting diode OLED may be improved and the luminance may be increased.

In some embodiments, the refractive index of the low refractive index material that may be used for the first insulating layer 531 is about 1.45 to about 1.55. In this case, the low refractive index material may include acrylic resin (e.g., polymethylmethacrylate, polyacrylic acid, etc.), ethylhexyl acrylate, pentafluoropropyl acrylate, poly(ethylene glycol)dimethacrylate, or ethylene glycol dimethacrylate.

The refractive index of the first insulating layer 531 may be equal to or similar to the refractive index of the encapsulation substrate 300. Because the refractive index of the first insulating layer 531 is equal to or similar to the refractive index of the encapsulation substrate 300, the light path of light passing through the first insulating layer 531 is not changed by the encapsulation substrate 300. Therefore, the light output path may be easily predicted. In some embodiments, the refractive indices of the first insulating layer 531 and the encapsulation substrate 300 may be about 1.45 to about 1.55.

In some embodiments, the refractive index of the high refractive index material that may be used for the second insulating layer 533 may be about 1.55 to about 1.7. In some embodiments, the second insulating layer 533 including the high refractive index material may include dispersed particles for a high refractive index. The dispersed particles may include metal oxide particles such as zinc oxide (ZnOₓ), titanium oxide (TiO₂), zirconium oxide (ZrO₂), and barium titanate (BaTiO₃). The second insulating layer 533 including the high refractive index material may be formed by applying an organic material including metal oxide particles by using inkjet.

In some embodiments, the second insulating layer 533 may include a color filter including a high refractive index material and having a certain color. Because the second insulating layer 533 includes the color filter, the color purity and visibility may be improved. The second insulating layer 533 may be configured to extract light corresponding to a certain color from light emitted from the organic light-emitting diode OLED. The second insulating layer 533 may implement a color in a wavelength band emitted from the corresponding organic light-emitting diode OLED. For example, the second insulating layer 533 implementing a red color may be on the organic light-emitting diode OLED emitting red light, the second insulating layer 533 implementing a green color may be on the organic light-emitting diode OLED emitting green light, and the second insulating layer 533 implementing a blue color may be on the organic light-emitting diode OLED emitting blue light.

In another embodiment, the second insulating layer 533 may include a reflection control layer that includes a high refractive index material and absorbs light in a specific wavelength band. The second insulating layer 533 may selectively absorb light having a wavelength of a partial band among light reflected from the inside of the display apparatus or light incident from the outside of the display apparatus.

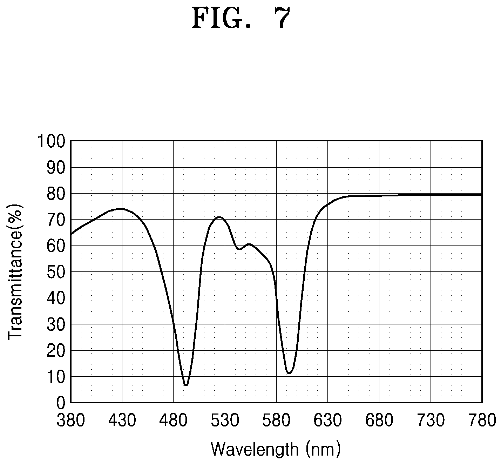

FIG. 7 shows transmittance characteristics when the second insulating layer 533 includes the reflection control layer. Referring to FIG. 7, the second insulating layer 533 absorbs a first wavelength band of about 480 nm to about 505 nm and a second wavelength band of about 585 nm to about 605 nm, and thus, the transmittance in the first wavelength band and the second wavelength band may be 50 % or less. That is, the second insulating layer 533 may absorb light having a wavelength out of the red, green, or blue emission wavelength range of the organic light-emitting diode OLED. The second insulating layer 533 may include an organic material layer including a dye, a pigment, or any combination thereof.

According to an embodiment, the second insulating layer 533 may include an oxazine-based compound, a cyanine-based compound, a tetraazoporphine-based compound, or a squarylium-based compound.

For example, the second insulating layer 533 may include a compound represented by one of Formulae 1 to 4:

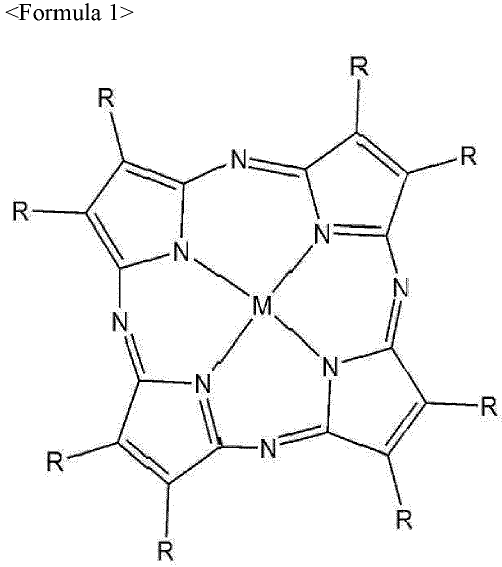

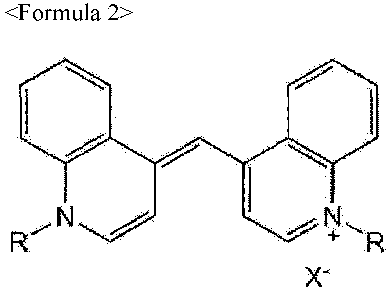

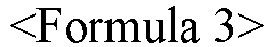

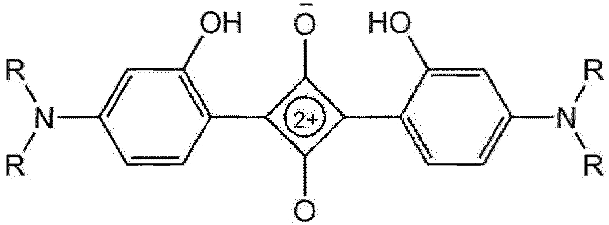

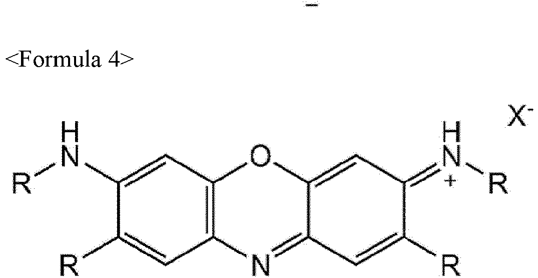

In Formulae 1 to 4,
M may be a metal,
X- may be a monovalent anion, and
R(s) may be different from each other and may each be selected from: hydrogen, deuterium (-D), -F, -Cl, -Br, -I, a hydroxyl group, a cyano group, or a nitro group;
a C1-C60 alkyl group, a C2-C60 alkenyl group, a C2-C60 alkynyl group, or a C1-C60 alkoxy group, unsubstituted or substituted with deuterium, -F, -Cl, -Br, -I, a hydroxyl group, a cyano group, a nitro group, a C3-C60 carbocyclic group, a C1-C60 heterocyclic group, a C6-C60 aryloxy group, a C6-C60 arylthio group, - Si(Q11)(Q12)(Q13), -N(Q11)(Q12), - B(Q11)(Q12), -C(=O)(Q11), -S(=O)2(Q11), -P(=O)(Q11)(Q12), or any combination thereof;
a C3-C60 carbocyclic group, a C1-C60 heterocyclic group, a C6-C60 aryloxy group, or a C6-C60 arylthio group, unsubstituted or substituted with deuterium, -F, -Cl, -Br, -I, a hydroxyl group, a cyano group, a nitro group, a C1-C60 alkyl group, a C2-C60 alkenyl group, a C2-C60 alkynyl group, a C1-C60 alkoxy group, a C3-C60 carbocyclic group, a C1-C60 heterocyclic group, a C6-C60 aryloxy group, a C6-C60 arylthio group, -Si(Q21)(Q22)(Q23), - N(Q21)(Q22), -B(Q21)(Q22), -C(=O)(Q21), -S(=O)2(Q21), -P(=O)(Q21)(Q22), or any combination thereof; or
-Si(Q31)(Q32)(Q33), -N(Q31)(Q32), -B(Q31)(Q32), -C(=O)(Q31), - S(=O)2(Q31), or -P(=O)(Q31)(Q32).
Qlto Q3, Q11 to Q13, Q21toQ23, and Q31to Q33 may each independently be selected from: hydrogen; heavy hydrogen; -F; -Cl; -Br; -I; a hydroxyl group; a cyano group; a nitro group; a C1-C60 alkyl group; a C2-C60 alkenyl group; a C2-C60 alkynyl group; a C1-C60 alkoxy group; or a C3-C60 carbocyclic group or a C1-C60 heterocyclic group, unsubstituted or substituted with deuterium, -F, a cyano group, a C1-C60 alkyl group, a C1-C60 alkoxy group, a phenyl group, a biphenyl group, or any combination thereof.

In an embodiment, X- may be halide ion, carboxylate ion, nitrate ion, sulfonate ion, or bisulfate ion.

For example, X- may be F-, Cl-, Br-, I-, CH3COO-, NO3-, HSO4-, propionate ion, benzenesulfonate ion, or the like.

In an embodiment, the reflectance measured on the surface of the second insulating layer 533 in a Specular Component Included (SCI) mode may be 10 % or less. That is, the second insulating layer 533 may absorb external light reflection of the display apparatus, thereby improving visibility.

In order to reduce external light reflection, the display apparatus according to the embodiments described herein does not use a polarizing film, but includes the second insulating layer 533 including the color filter or the reflection control layer.

On the other hand, the following processes may be performed so as to form the refractive layer 530.

First, the first insulating layer 531 may be formed by applying an organic material having a low refractive index onto the lower surface of the encapsulation substrate 300, and a photo-patterning process may be performed thereon to form the opening 531_OP of the first insulating layer 531. The first insulating layer 531 may be formed by performing curing at a high temperature.

The second insulating layer 533 may be formed by filling the opening 53 1_OP of the first insulating layer 531 with an organic material having a high refractive index and then performing curing thereon. In this case, the second insulating layer 533 may be formed by a photo process or an inkjet process.

In this case, the width W3u of the upper portion of the opening 531_OP of the first insulating layer 531 may be equal to the width W3u of the upper portion of the second insulating layer 533. The width W3u of the upper portion of the opening 531_OP of the first insulating layer 531 may be less than the width of the lower portion of the opening 531_OP of the first insulating layer 531.

The method of forming the refractive layer 530 is not limited thereto. Various methods may be used. As illustrated in FIG. 6B, the second insulating layer 533 is formed by patterning on the lower surface of the encapsulation substrate 300, and the first insulating layer 531 fills a space in which the second insulating layer 533 is not arranged.

Also, although FIG. 6A illustrates that the thickness of the second insulating layer 533 is less than the thickness of the first insulating layer 531, the disclosure is not limited thereto. Various modifications may be made thereto. As illustrated in FIG. 6B, the thickness of the second insulating layer 533 may be greater than or equal to the thickness of the first insulating layer 531.

The light blocking layer 510 may be in direct contact with the lower surface of the first insulating layer 531. The light blocking layer 510 may include a material that blocks most of visible light. That is, the light blocking layer 510 may have a wavelength spectrum that generally absorbs a wavelength of a visible light band, for example, about 380 nm to about 780 nm. The light blocking layer 510 may be black. For example, the light blocking layer 510 may include carbon black, carbon nanotubes, a resin or paste including black dye, metal particles (e.g., nickel, aluminum, molybdenum, and any alloy thereof), metal oxide particles (e.g., chromium oxide), or metal nitride particles (e.g., chromium nitride).

The light blocking layer 510 may be formed by applying a light blocking material onto the lower surface of the first insulating layer 531, performing a photo-patterning process to form the openings 510_OP of the light blocking layer 510, and then performing curing thereon. A thickness t1 of the light blocking layer 510 may be less than a thickness t2 of the first insulating layer 531.

The light blocking layer 510 includes the opening 510_OP overlapping the emission area EA of the organic light-emitting diode OLED. The emission area EA may be defined by the opening OP of the pixel defining layer 209. The opening 510_OP of the light blocking layer 510 overlaps the opening 53 1_OP of the first insulating layer 531. The opening 510_OP of the light blocking layer 510 overlaps the second insulating layer 533.

In some embodiments, the opening 510_OP of the light blocking layer 510 overlaps the opening OP of the pixel defining layer 209, and the second width W2 that is the width of the opening 510_OP of the light blocking layer 510 may be greater than the first width W1 that is the width of the opening OP of the pixel defining layer 209. Also, the second width W2 may be less than the third width W3u that is the upper width of the second insulating layer 533. Although the third width W3u is illustrated as being greater than the first width W1, the disclosure is not limited thereto. Various modifications may be made thereto. For example, the third width W3u may be equal to or less than the first width W1.

In some embodiments, a filling member 600 may be between the display substrate 100 and the encapsulation substrate 300. That is, the filling member 600 may fill a space between the organic light-emitting diode OLED and the optical layer 500. The refractive index of the filling member 600 may be similar to the refractive index of the second insulating layer 533. In some embodiments, the refractive index of the filling member 600 may be about 1.55 to about 1.7. Because the refractive index of the filling member 600 is similar to the refractive index of the second insulating layer 533, the optical path may be easily predicted. After the filling member 600 is applied before the display substrate 100 on which the organic light-emitting diode OLED is formed is bonded to the encapsulation substrate 300 on which the optical layer 500 is formed, the display substrate 100 may be bonded to the encapsulation substrate 300.

However, the embodiments described herein are not limited thereto. The filling member 600 having a refractive index lower than that of the second insulating layer 533 may or may not be filled between the display substrate 100 and the encapsulation substrate 300.

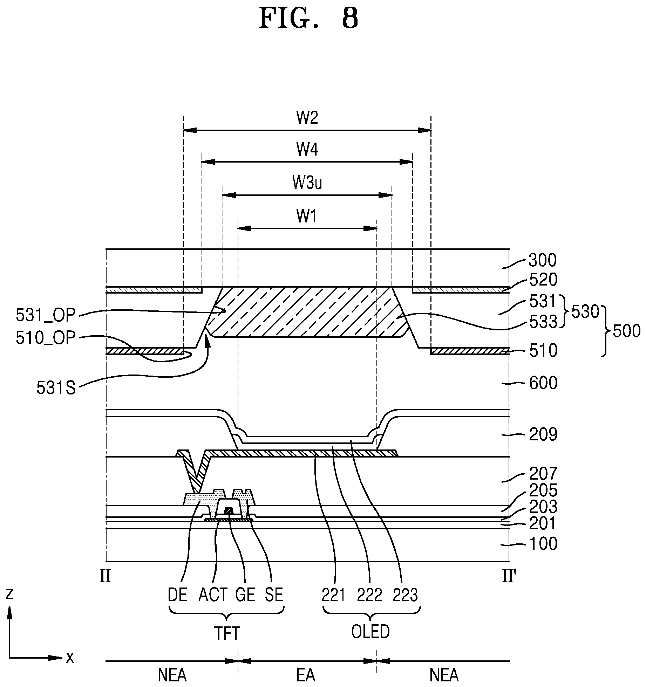

FIG. 8 is a cross-sectional view schematically illustrating a portion of a display apparatus according to an embodiment. In FIG. 8, the same reference numerals as those in FIG. 6A denote the same members, and redundant descriptions thereof are omitted for ease in explanation of FIG. 8.

Referring to FIG. 8, the display apparatus according to an embodiment includes an organic light-emitting diode OLED as a display element including an emission area EA on a display substrate 100, an encapsulation substrate 300 encapsulating the display element, and an optical layer 500 on the lower surface of the encapsulation substrate 300.

The optical layer 500 includes a refractive layer 530 and a light blocking layer 510. The refractive layer 530 includes a first insulating layer 531 and a second insulating layer 533 on the lower surface of the encapsulation substrate 300, and the light blocking layer 510 is on the lower surface of the first insulating layer 531.

The first insulating layer 531 may include a low refractive index material, and the second insulating layer 533 may include a high refractive index material. In the claimed invention, the first insulating layer 531 is arranged to correspond to the non-emission area NEA, and the second insulating layer 533 is arranged to correspond to the emission area EA. A cross-sectional shape of the second insulating layer 533 may be a trapezoidal shape. The area of the second insulating layer 533 may gradually increase as the distance to the display substrate 100 decreases. The side surface of the second insulating layer 533 may be inclined with respect to the lower surface of the encapsulation substrate 300. The side surface of the second insulating layer 533 may have an inclination angle θ of about 50° to 60° with respect to the lower surface of the encapsulation substrate 300.

The second insulating layer 533 may include a color filter configured to make a color in a wavelength band emitted by the organic light-emitting diode OLED. Alternatively, the second insulating layer 533 may include a reflection control layer configured to selectively absorb blight having a wavelength of a partial band.

In the claimed invention, the optical layer 500 further includes an upper light blocking layer 520 between the encapsulation substrate 300 and the first insulating layer 531. The upper light blocking layer 520 may be in direct contact with the lower surface of the encapsulation substrate 300. The upper light blocking layer 520 may be arranged considering external light reflection and viewing angle. The upper light blocking layer 520 includes an opening 520_OP corresponding to the emission area EA. The fourth width W4, which is the width of the opening 520_OP, may be greater than the first width W1 and is less than the second width W2.

Because the upper light blocking layer 520 is provided, color mixing of light emitted from each pixel may be prevented, and externally reflected light may be remarkably reduced.

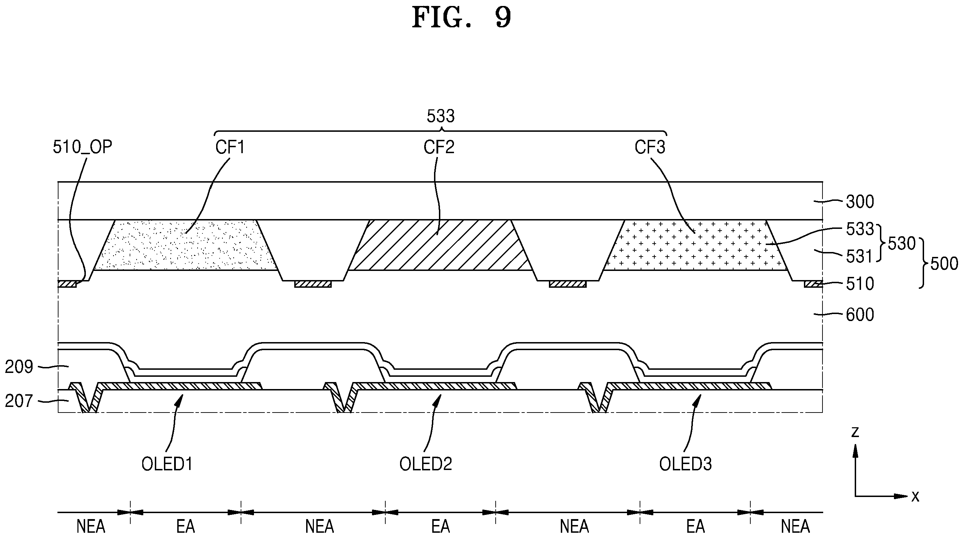

FIG. 9 is a cross-sectional view schematically illustrating a portion of a display apparatus according to an embodiment not forming part of the claimed invention. In FIG. 9, the same reference numerals as those in FIG. 6A denote the same members, and redundant descriptions thereof are omitted for ease in explanation of FIG. 9.

Referring to FIG. 9, a first organic light-emitting diode OLED1, a second organic light-emitting diode OLED2, and a third organic light-emitting diode OLED3, which emit different colors from each other, may be on a display substrate (see 100 of FIG. 6A).

In the claimed invention, an optical layer 500 is on a lower surface of an encapsulation substrate 300. The optical layer 500 includes a first insulating layer 531 having a low refractive index, a second insulating layer 533 having a high refractive index, and a light blocking layer 510 on the lower surface of the first insulating layer 531. The second insulating layer 533 is arranged to correspond to emission areas EA, and the first insulating layer 531 is arranged to correspond to non-emission areas NEA between the emission areas EA. The first insulating layer 531 may have a refractive index of about 1.5 with respect to a wavelength of about 550 nm.

In the embodiment described herein, the second insulating layer 533 may include a color filter having a high refractive index. The second insulating layer 533 may include a first color filter CF1, a second color filter CF2, and a third color filter CF3, which have different colors from each other.

The first color filter CF1 may be arranged to correspond to the first organic light-emitting diode OLED1. When the first organic light-emitting diode OLED1 emits red light, the first color filter CF1 may be a red color filter. The first color filter CF1 may have a refractive index of about 1.65 with respect to a wavelength of about 630 nm.

The second color filter CF2 may be arranged to correspond to the second organic light-emitting diode OLED2. When the second organic light-emitting diode OLED2 emits green light, the second color filter CF2 may be a green color filter. The second color filter CF2 may have a refractive index of about 1.57 with respect to a wavelength of about 550 nm.

The third color filter CF3 may be arranged to correspond to the third organic light-emitting diode OLED3. When the third organic light-emitting diode OLED3 emits blue light, the third color filter CF3 may be a blue color filter. The third color filter CF3 may have a refractive index of about 1.61 with respect to a wavelength of about 410 nm.

In the claimed invention, the light blocking layer 510 is arranged to correspond to the non-emission area NEA on the lower surface of the first insulating layer 531. The light blocking layer 510 may have a wavelength spectrum that generally absorbs a wavelength of a visible light band, for example, about 380 nm to about 780 nm. The light blocking layer 510 may be black.

Because the display apparatus according to an embodiment includes the first insulating layer 531 having a low refractive index and the second insulating layer 533 having a high refractive index, light output efficiency may be improved. Also, because the second insulating layer 533 includes the color filter and the light blocking layer 510 is provided, external light reflection may be prevented and visibility may be improved without introducing a polarizing film.

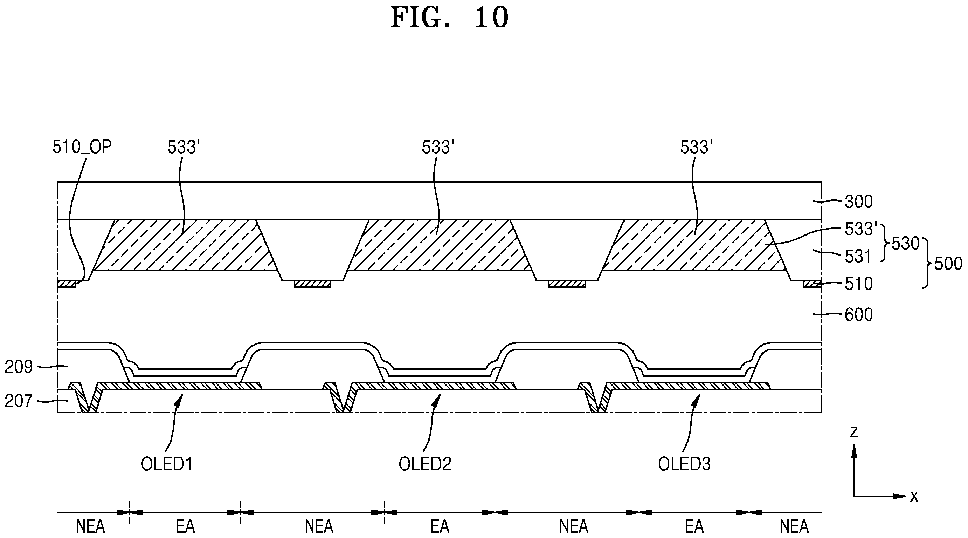

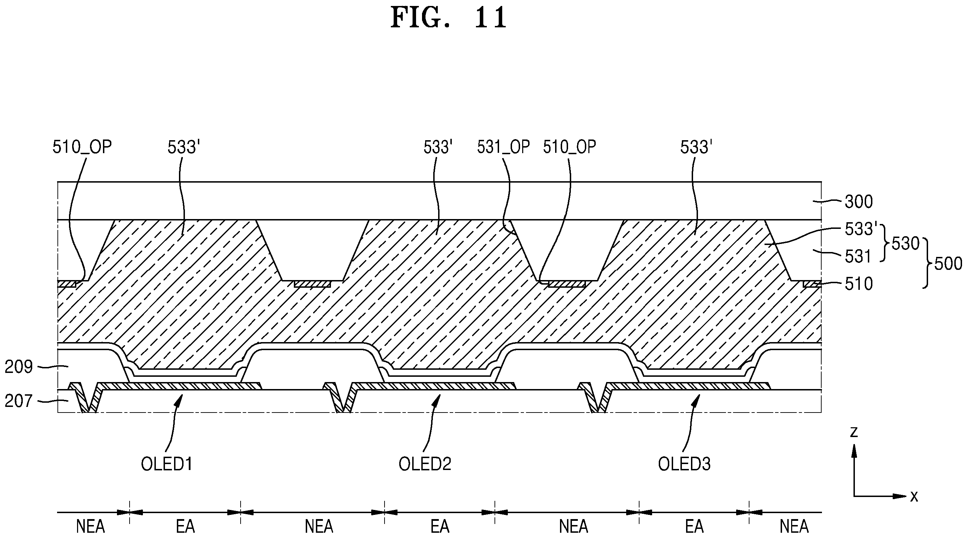

FIGS. 10 and 11 are cross-sectional views schematically illustrating a portion of a display apparatus according to an embodiment not forming part of the claimed invention. In FIGS. 10 and 11, the same reference numerals as those in FIG. 6A denote the same members, and redundant descriptions thereof are omitted for ease in explanation of FIGS. 10 and 11.

Referring to FIG. 10, a first organic light-emitting diode OLED1, a second organic light-emitting diode OLED2, and a third organic light-emitting diode OLED3, which emit different colors from each other, may be on a display substrate (see 100 of FIG. 6A).

In the claimed invention, an optical layer 500 is on a lower surface of an encapsulation substrate 300. The optical layer 500 includes a first insulating layer 531 having a low refractive index, a second insulating layer 533' having a high refractive index, and a light blocking layer 510 on the lower surface of the first insulating layer 531. The second insulating layer 533' is arranged to correspond to emission areas EA, and the first insulating layer 531 is arranged to correspond to non-emission areas NEA between the emission areas EA. The first insulating layer 531 may have a refractive index of about 1.5 with respect to a wavelength of about 550 nm. The second insulating layer 533' may have a refractive index of about 1.6 to about 1.7 with respect to a wavelength of about 550 nm.

In the embodiment described herein, the second insulating layer 533' may include a reflection control layer. The second insulating layer 533' absorbs a first wavelength band of about 480 nm to about 505 nm and a second wavelength band of about 585 nm to about 605 nm, and thus, the transmittance in the first wavelength band and the second wavelength band may be 50 % or less. That is, the second insulating layer 533' may absorb light having a wavelength out of the red, green, or blue emission wavelength range of the organic light-emitting diode OLED.

When the second insulating layer 533' includes a reflection control layer, the second insulating layer 533' may be commonly on the first organic light-emitting diode OLED1, the second organic light-emitting diode OLED2, and the third organic light-emitting diode OLED3.

The second insulating layer 533' is on the first organic light-emitting diode OLED1, the second organic light-emitting diode OLED2, and the third organic light-emitting diode OLED3 in the same configuration, thereby improving visibility and simplifying the process.

Similarly, the light blocking layer 510 and the first insulating layer 531 may be on the first organic light-emitting diode OLED1, the second organic light-emitting diode OLED2, and the third organic light-emitting diode OLED3 in the same configuration.

The light blocking layer 510 may have a wavelength spectrum that generally absorbs a wavelength of a visible light band, for example, about 380 nm to about 780 nm. The light blocking layer 510 may be black.

A filling member 600 may be between the first, second, and third organic light-emitting diodes OLED1, OLED2, and OLED3 and the optical layer 500. The filling member 600 may include a transparent organic material having high transmittance. In some embodiments, the filling member 600 may include a high refractive index material having a refractive index of about 1.6 to about 1.7.

Although FIG. 10 illustrates that the filling member 600 is arranged separately from the second insulating layer 533' between the first, second, and third organic light-emitting diodes OLED1, OLED2, and OLED3 and the optical layer 500, the embodiment described herein is not limited thereto.

As illustrated in FIG. 11, the filling member 600 is not provided separately and may fill a space between the first, second, and third organic light-emitting diodes OLED1, OLED2, and OLED3 and the light blocking layer 510. That is, the second insulating layer 533' may act as the filling member.

As described above, according to one or more embodiments, because the refractive layer and the light blocking layer are provided on the lower surface of the encapsulation substrate, light extraction efficiency and visibility may be improved.

Although certain embodiments and implementations have been described herein, other embodiments and modifications will be apparent from this description. Accordingly, the inventive concepts are not limited to such embodiments, but rather to the broader scope of the appended claims.

## Claims

1. A display apparatus (1) comprising:
a display substrate (100);
a plurality of display elements provided on the display substrate (100) and configured to emit light;
an encapsulation substrate (300) provided on the plurality of display elements to face the display substrate (100);
a refractive layer (530) provided on a lower surface of or below the encapsulation substrate (300), the refractive layer (530) comprising a first insulating layer (531) having a first refractive index and a second insulating layer (533, 533') having a second refractive index greater than the first refractive index; and
a light blocking layer (510) provided on a lower surface of or below the refractive layer (530), wherein
the first insulating layer (531) and the light blocking layer (510) are arranged to correspond to non-emission areas (NEA) between the plurality of display elements, and
the second insulating layer (533, 533') is arranged to correspond to emission areas (EA) of the plurality of display elements, and a width (W3u) of an upper surface of the second insulating layer (533, 533') in the emission areas (EA) is less than a width (W3d) of a lower surface of the second insulating layer (533, 533'), and the first insulating layer (531) and the second insulating layer (533, 533') being in direct contact with the encapsulation substrate (300);
further comprising an upper light blocking layer (520) provided between the encapsulation substrate (300) and the first insulating layer (531);
wherein the upper light blocking layer (520) comprises a first opening (520_OP) corresponding to the emission area (EA), the light blocking layer (510) comprises a second opening (510_OP) corresponding to the emission area (EA), and a width (W4) of the first opening (520_OP) is less than a width (W2) of the second opening (510_OP).

2. The display apparatus (1) of claim 1, wherein an angle (θ) at which a side surface of the second insulating layer (533, 533') is inclined with respect to a lower surface of the encapsulation substrate (300) is about 50° to about 60°.

3. The display apparatus (1) of claim 1 or 2, wherein the first refractive index is about 1.45 to about 1.55, and the second refractive index is about 1.55 to about 1.7.

4. The display apparatus (1) of at least one of claims 1 to 3, wherein the second insulating layer (533, 533') comprises a color filter (CF1, CF2, CF3).

5. The display apparatus (1) of at least one of claims 1 to 4, wherein the second insulating layer (533, 533') comprises a reflection control layer configured to selectively absorb a first wavelength band and a second wavelength band of a visible light band.

6. The display apparatus (1) of claim 5, wherein the first wavelength band is 480 nm to 505 nm, and the second wavelength band is 585 nm to 605 nm.

7. The display apparatus (1) of at least one of claims 1 to 6, wherein the width (W2) of a respective opening (510_OP) of the light blocking layer (510) is greater than the width (W3u) of the upper surface of the second insulating layer (533, 533').

8. The display apparatus (1) of at least one of claims 1 to 7, wherein a thickness (t1) of the light blocking layer (510) is less than a thickness (t2) of the first insulating layer (531).

9. The display apparatus (1) according to at least one of claims 1 to 8, comprising:
a first display element, a second display element, and a third display element, which are on the display substrate (100) and are configured to emit light of different colors;
the encapsulation substrate (300) is provided on the first display element, the second display element, and the third display element to face the display substrate (100);
the openings (510_OP) of the light blocking layer (510) correspond to emission areas (EA) of the first display element, the second display element, and the third display element; and
wherein the second insulating layer (533') is arranged to correspond to the emission areas (EA) of the first display element, the second display element, and the third display element.

10. The display apparatus (1) of claim 9, wherein the second insulating layer (533') comprises a first color filter (CF1), a second color filter (CF2), and a third color filter (CF3) configured to emit different colors from each other, and the first color filter (CF1), the second color filter (CF2), and the third color filter (CF3) are arranged to correspond to the first display element, the second display element, and the third display element, respectively.

11. The display apparatus (1) of claims 9 or 10, wherein the second insulating layer (533') is provided as one common part on the first display element, the second display element, and the third display element.

12. The display apparatus (1) of at least one of claims 9 to 11, wherein the second insulating layer (533') extends between the first, second, and third display elements and the light blocking layer (510).

## Patentansprüche

1. Eine Anzeigevorrichtung (1), umfassend:
ein Anzeige-Substrat (100);
eine Vielzahl von Anzeigeelementen, bereitgestellt auf dem Anzeige-Substrat (100) und konfiguriert, um Licht zu emittieren;
ein Verkapselungs-Substrat (300), bereitgestellt auf der Vielzahl von Anzeigeelementen, um dem Anzeige-Substrat (100) gegenüberzuliegen;
eine Brechungsschicht (530), bereitgestellt auf einer unteren Oberfläche des Verkapselungs-Substrats (300) oder unterhalb des Verkapselungs-Substrats (300), wobei die Brechungsschicht (530) eine erste Isolierschicht (531) mit einem ersten Brechungsindex und eine zweite Isolierschicht (533, 533') mit einem zweiten Brechungsindex umfasst, der größer ist als der erste Brechungsindex; und eine Lichtblockierschicht (510), bereitgestellt auf einer unteren Oberfläche der Brechungsschicht (530) oder unterhalb der Brechungsschicht (530), wobei die erste Isolierschicht (531) und die Lichtblockierschicht (510) so angeordnet sind, dass sie Nicht-Emissionsbereichen (NEA) zwischen der Vielzahl von Anzeigeelementen entsprechen, und
die zweite Isolierschicht (533, 533') so angeordnet ist, dass sie Emissionsbereichen (EA) der Vielzahl von Anzeigeelementen entspricht, und eine Breite (W3u) einer oberen Oberfläche der zweiten Isolierschicht (533, 533') in den Emissionsbereichen (EA) kleiner ist als eine Breite (W3d) einer unteren Oberfläche der zweiten Isolierschicht (533, 533'), und die erste Isolierschicht (531) und die zweite Isolierschicht (533, 533') in direktem Kontakt mit dem Verkapselungs-Substrat (300) sind;
ferner umfassend eine obere Lichtblockierschicht (520), bereitgestellt zwischen dem Verkapselungs-Substrat (300) und der ersten Isolierschicht (531);
wobei die obere Lichtblockierschicht (520) eine erste Öffnung (520_OP) umfasst, die dem Emissionsbereich (EA) entspricht, die Lichtblockierschicht (510) eine zweite Öffnung (510_OP) umfasst, die dem Emissionsbereich (EA) entspricht, und eine Breite (W4) der ersten Öffnung (520_OP) kleiner ist als eine Breite (W2) der zweiten Öffnung (510_OP).

2. Die Anzeigevorrichtung (1) nach Anspruch 1, wobei ein Winkel (θ), mit dem eine Seitenoberfläche der zweiten Isolierschicht (533, 533') relativ zu einer unteren Oberfläche des Verkapselungs-Substrats (300) geneigt ist, etwa 50° bis etwa 60° beträgt.

3. Die Anzeigevorrichtung (1) nach Anspruch 1 oder 2, wobei der erste Brechungsindex etwa 1,45 bis etwa 1,55 beträgt, und der zweite Brechungsindex etwa 1,55 bis etwa 1,7 beträgt.

4. Die Anzeigevorrichtung (1) nach mindestens einem der Ansprüche 1 bis 3, wobei die zweite Isolierschicht (533, 533') einen Farbfilter (CF1, CF2, CF3) umfasst.

5. Die Anzeigevorrichtung (1) nach mindestens einem der Ansprüche 1 bis 4, wobei die zweite Isolierschicht (533, 533') eine Reflexionskontrollschicht umfasst, die konfiguriert ist, um selektiv ein erstes Wellenlängenband und ein zweites Wellenlängenband eines sichtbaren Lichtbands zu absorbieren.

6. Die Anzeigevorrichtung (1) nach Anspruch 5, wobei das erste Wellenlängenband 480 nm bis 505 nm beträgt, und das zweite Wellenlängenband 585 nm bis 605 nm beträgt.

7. Die Anzeigevorrichtung (1) nach mindestens einem der Ansprüche 1 bis 6, wobei die Breite (W2) einer jeweiligen Öffnung (510_OP) der Lichtblockierschicht (510) größer ist als die Breite (W3u) der oberen Oberfläche der zweiten Isolierschicht (533, 533').

8. Die Anzeigevorrichtung (1) nach mindestens einem der Ansprüche 1 bis 7, wobei eine Dicke (t1) der Lichtblockierschicht (510) kleiner ist als eine Dicke (t2) der ersten Isolierschicht (531).

9. Die Anzeigevorrichtung (1) nach mindestens einem der Ansprüche 1 bis 8, umfassend:
ein erstes Anzeigeelement, ein zweites Anzeigeelement und ein drittes Anzeigeelement, die auf dem Anzeige-Substrat (100) sind und konfiguriert sind, um Licht von unterschiedlichen Farben zu emittieren;
das Verkapselungs-Substrat (300) ist bereitgestellt auf dem ersten Anzeigeelement, dem zweiten Anzeigeelement und dem dritten Anzeigeelement, um dem Anzeige-Substrat (100) gegenüberzuliegen;
die Öffnungen (510_OP) der Lichtblockierschicht (510) entsprechen Emissionsbereichen (EA) des ersten Anzeigeelements, des zweiten Anzeigeelements und des dritten Anzeigeelements; und wobei die zweite Isolierschicht (533') so angeordnet ist, dass sie den Emissionsbereichen (EA) des ersten Anzeigeelements, des zweiten Anzeigeelements und des dritten Anzeigeelements entspricht.

10. Die Anzeigevorrichtung (1) nach Anspruch 9, wobei die zweite Isolierschicht (533') einen ersten Farbfilter (CF1), einen zweiten Farbfilter (CF2) und einen dritten Farbfilter (CF3) umfasst, die konfiguriert sind, um unterschiedliche Farben voneinander zu emittieren, und der erste Farbfilter (CF1), der zweite Farbfilter (CF2) und der dritte Farbfilter (CF3) so angeordnet sind, dass sie jeweils dem ersten Anzeigeelement, dem zweiten Anzeigeelement und dem dritten Anzeigeelement entsprechen.

11. Die Anzeigevorrichtung (1) nach Anspruch 9 oder 10, wobei die zweite Isolierschicht (533') als ein gemeinsamer Teil auf dem ersten Anzeigeelement, dem zweiten Anzeigeelement und dem dritten Anzeigeelement bereitgestellt ist.

12. Die Anzeigevorrichtung (1) nach mindestens einem der Ansprüche 9 bis 11, wobei sich die zweite Isolierschicht (533') zwischen dem ersten, zweiten und dritten Anzeigeelement und der Lichtblockierschicht (510) erstreckt.

## Revendications

1. Appareil d'affichage (1) comprenant :
un substrat d'affichage (100) ;
une pluralité d'éléments d'affichage ménagés sur le substrat d'affichage (100) et configurés pour émettre de la lumière ;
un substrat d'encapsulation (300) ménagé sur la pluralité d'éléments d'affichage de façon à faire face au substrat d'affichage (100) ;
une couche réfractive (530) ménagée sur une surface inférieure ou en-dessous du substrat d'encapsulation (300), la couche réfractive (530) comprenant une première couche isolante (531) présentant un premier indice de réfraction et une deuxième couche isolante (533, 533') présentant un deuxième indice de réfraction supérieur au premier indice de réfraction ; et
une couche de blocage de lumière (510) ménagée sur une surface inférieure ou en-dessous de la couche réfractive (530), dans lequel
la première couche isolante (531) et la couche de blocage de lumière (510) sont disposées de façon à correspondre à des zones de non-émission (NEA) entre la pluralité d'éléments d'affichage, et
la deuxième couche isolante (533, 533') est disposée de façon à correspondre à des zones d'émission (EA) de la pluralité d'éléments d'affichage, et une largeur (W3u) d'une surface supérieure de la deuxième couche isolante (533, 533') dans les zones d'émission (EA) est plus petite qu'une largeur (W3d) d'une surface inférieure de la deuxième couche isolante (533, 533'), et la première couche isolante (531) et la deuxième couche isolante (533, 533') étant en contact direct avec le substrat d'encapsulation (300) ;
comprenant en outre une couche de blocage de lumière supérieure (520) ménagée entre le substrat d'encapsulation (300) et la première couche isolante (531) ;
dans lequel la couche de blocage de lumière supérieure (520) comprend une première ouverture (520_OP) correspondant à la zone d'émission (EA), la couche de blocage de lumière (510) comprend une deuxième ouverture (510_OP) correspondant à la zone d'émission (EA), et une largeur (W4) de la première ouverture (520_OP) est plus petite qu'une largeur (W2) de la deuxième ouverture (510_OP).

2. Appareil d'affichage (1) selon la revendication 1, dans lequel un angle (θ) duquel une surface latérale de la deuxième couche isolante (533, 533') est inclinée par rapport à une surface inférieure du substrat d'encapsulation (300) est d'environ 50° à environ 60°.

3. Appareil d'affichage (1) selon la revendication 1 ou 2, dans lequel le premier indice de réfraction est d'environ 1,45 à environ 1,55, et le deuxième indice de réfraction est d'environ 1,55 à environ 1,7.

4. Appareil d'affichage (1) selon au moins l'une des revendications 1 à 3, dans lequel la deuxième couche isolante (533, 533') comprend un filtre coloré (CF1, CF2, CF3).

5. Appareil d'affichage (1) selon au moins l'une des revendications 1 à 4, dans lequel la deuxième couche isolante (533, 533') comprend une couche de commande de réflexion configurée pour absorber de manière sélective une première bande de longueurs d'onde et une deuxième bande de longueurs d'onde d'une bande de lumière visible.

6. Appareil d'affichage (1) selon la revendication 5, dans lequel la première bande de longueurs d'onde est de 480 nm à 505 nm, et la deuxième bande de longueurs d'onde est de 585 nm à 605 nm.

7. Appareil d'affichage (1) selon au moins l'une des revendications 1 à 6, dans lequel la largeur (W2) d'une ouverture respective (510_OP) de la couche de blocage de lumière (510) est plus grande que la largeur (W3u) de la surface supérieure de la deuxième couche isolante (533, 533').

8. Appareil d'affichage (1) selon au moins l'une des revendications 1 à 7, dans lequel une épaisseur (t1) de la couche de blocage de lumière (510) est plus petite qu'une épaisseur (t2) de la première couche isolante (531).

9. Appareil d'affichage (1) selon au moins l'une des revendications 1 à 8, comprenant :
un premier élément d'affichage, un deuxième élément d'affichage et un troisième élément d'affichage, qui se trouvent sur le substrat d'affichage (100) et sont configurés pour émettre de la lumière de différentes couleurs ;
le substrat d'encapsulation (300) est ménagé sur le premier élément d'affichage, le deuxième élément d'affichage et le troisième élément d'affichage de façon à faire face au substrat d'affichage (100) ;
les ouvertures (510_OP) de la couche de blocage de lumière (510) correspondent à des zones d'émission (EA) du premier élément d'affichage, du deuxième élément d'affichage et du troisième élément d'affichage ; et
dans lequel la deuxième couche isolante (533') est disposée de façon à correspondre aux zones d'émission (EA) du premier élément d'affichage, du deuxième élément d'affichage et du troisième élément d'affichage.

10. Appareil d'affichage (1) selon la revendication 9, dans lequel la deuxième couche isolante (533') comprend un premier filtre coloré (CF1), un deuxième filtre coloré (CF2) et un troisième filtre coloré (CF3) configurés pour émettre des couleurs différentes les unes des autres, et le premier filtre coloré (CF1), le deuxième filtre coloré (CF2) et le troisième filtre coloré (CF3) sont disposés de façon à correspondre au premier élément d'affichage, au deuxième élément d'affichage et au troisième élément d'affichage, respectivement.

11. Appareil d'affichage (1) selon les revendications 9 ou 10, dans lequel la deuxième couche isolante (533') est ménagée comme une partie commune sur le premier élément d'affichage, le deuxième élément d'affichage et le troisième élément d'affichage.

12. Appareil d'affichage (1) selon au moins l'une des revendications 9 à 11, dans lequel la deuxième couche isolante (533') s'étend entre les premier, deuxième et troisième éléments d'affichage et la couche de blocage de lumière (510).
